(19) Europäisches Patentamt
European Patent Office
Office européen des brevets

(11) **EP 4 266 700 A1**

(12) **EUROPEAN PATENT APPLICATION**
published in accordance with Art. 153(4) EPC

(43) Date of publication:
**25.10.2023 Bulletin 2023/43**

(21) Application number: **22865877.9**

(22) Date of filing: **04.03.2022**

(51) International Patent Classification (IPC):
**H04R 1/10** *(2006.01)* **H04R 9/04** *(2006.01)*

(86) International application number:
**PCT/CN2022/079435**

(87) International publication number:
**WO 2023/164953 (07.09.2023 Gazette 2023/36)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **Shenzhen Shokz Co., Ltd.
Shenzhen, Guangdong 518108 (CN)**

(72) Inventors:
• **ZHU, Guangyuan
Shenzhen, Guangdong 518108 (CN)**
• **ZHANG, Lei
Shenzhen, Guangdong 518108 (CN)**
• **QI, Xin
Shenzhen, Guangdong 518108 (CN)**
• **WANG, Qingyi
Beijing 100015 (CN)**

(74) Representative: **Wang, Bo
Panovision IP
Ebersberger Straße 3
85570 Markt Schwaben (DE)**

(54) **ACOUSTIC DEVICE**

(57) An acoustic device comprises: a piezoelectric component which vibrates under the action of a driving voltage; a vibration component which is mechanically connected to the piezoelectric component to receive a vibration and produce sound; and a resistor element which is connected in series with the piezoelectric component to change a frequency response of the vibration component, wherein the resistor element makes a difference between a vibration amplitude of the vibration component at 10 kHz and a vibration amplitude of the vibration component at 1 kHz less than or equal to 20 dB. The resistor element is connected in series, so that the vibration amplitude of the vibration component in mid-and-high frequency bands can be reduced, a sensitivity difference of the full frequency band can be reduced, and high-and-low frequency equalization of the sound output from the acoustic device can be improved. Moreover, when the acoustic device is in the mid-and-high frequency bands, the resistor element connected in series may also reduce the current flowing through the piezoelectric component by voltage division, thereby reducing the heat energy generated by the piezoelectric component, achieving the effect of temperature control, and improving the operation reliability of the acoustic device.

FIG. 1

EP 4 266 700 A1

## Description

## TECHNICAL FIELD

The present disclosure relates to the technical field of acoustics, and in particular to acoustic devices.

## BACKGROUND

Acoustic devices often transmit sound by applying electrical energy to piezoelectric components to cause the piezoelectric components to deform. For example, an acoustic device may radiate sound waves outward by applying a driving voltage in a direction of polarization of a piezoelectric component to produce vibrations based on an inverse piezoelectric effect of the piezoelectric component.

However, a resonant frequency of the piezoelectric component of the acoustic device is usually high, resulting in a high high-frequency sensitivity and a low low-frequency sensitivity of the acoustic device. Thus the sound produced BY the acoustic device is often harsh, and the user's sense of high-and-low frequency equalization is often poor.

In addition, after an alternating voltage signal is applied to the piezoelectric component, the piezoelectric component may produce heat under the action of an internal resistance of the piezoelectric component, and the heat approaches or even exceeds 300°C near the resonance frequency. The piezoelectric component is piezoelectric, and an operation temperature thereof must be lower than the Curie temperature of thereof. Therefore, how to effectively control the operation temperature of the piezoelectric component under the alternating signal has become the key to improve the operation reliability of the acoustic device driven by the piezoelectric component.

Accordingly, it is desirable to provide acoustic devices which has high-and-low frequency sensitivity equalization and effectively controls the heat produced at mid-and-high frequency.

## SUMMARY

One of the embodiments of the present disclosure provides an acoustic device. The acoustic device comprises: a piezoelectric component which may produce a vibration under an action of a driving voltage; a vibration component mechanically connected to the piezoelectric component to receive the vibration and produce sound; and a resistor element connected in series with the piezoelectric component to change a frequency response of the vibration component, wherein the resistor element may be configured that a difference between a vibration amplitude of the vibration component at 10 kHz and a vibration amplitude of the vibration component at 1 kHz is less than or equal to 20 dB.

In some embodiments, the resistor element may be connected in series on a positive electrode of the piezoelectric component.

In some embodiments, the resistor element may be welded on the positive electrode of the piezoelectric component.

In some embodiments, the resistor element may be connected in series with a negative electrode of the piezoelectric component.

In some embodiments, the resistor element may be welded on the negative electrode of the piezoelectric component.

In some embodiments, the positive electrode and the negative electrode of the piezoelectric component may be led out from a same side of the piezoelectric component.

In some embodiments, the resistor element may include a lead connected with the piezoelectric component.

In some embodiments, the resistor element may include a conductive adhesive connected with the piezoelectric component.

In some embodiments, the resistor element may be arranged on a flexible circuit board.

In some embodiments, the resistor element may include an electrode of the piezoelectric component.

In some embodiments, at least part of the electrode of the piezoelectric component may be made of one of: copper, gold, aluminum, tungsten, iron, or platinum.

In some embodiments, an effective cross-sectional area of at least part of the electrode of the piezoelectric component may be less than a contour cross-sectional area of the electrode.

In some embodiments, a cross-section of at least part of the electrode of the piezoelectric component may be a mesh structure or an S-shaped structure.

In some embodiments, a resistance value of the resistor element may be within a range of $1\Omega$-$1k\Omega$.

In some embodiments, the piezoelectric component may be a beam structure.

In some embodiments, the piezoelectric component may include at least two piezoelectric ceramic wafers. The at least two piezoelectric ceramic wafers may be electrically connected with each other.

In some embodiments, the at least two piezoelectric ceramic wafers may be interleaved with electrodes of the piezoelectric component.

In some embodiments, in an operation state, a surface temperature of the piezoelectric component may be lower than a Curie temperature of the piezoelectric component.

In some embodiments, the vibration component may include: an elastic element; and a mass element. One end of the elastic element may be connected with the piezoelectric component, and the other end of the elastic element may be connected with the mass element.

In some embodiments, the elastic element may include one of: a vibration transmitting sheet, an adhesive, an elastic sheet, or a substrate.

In some embodiments, the mass element may include a housing configured to accommodate the piezoelectric component and the resistor element.

In some embodiments, the acoustic device may be a bone conduction acoustic device.

In some embodiments, the acoustic device may further include a boost electrical system configured to increase a voltage output from a power supply.

In the embodiments, the resistor element and the piezoelectric component may be connected in series for voltage division, and the voltage at both ends of the piezoelectric component may be reduced, thereby reducing the vibration amplitude of the vibration component in mid-and-high frequency band, reducing the sensitivity difference of the full frequency band, and improving the high-and-low frequency equalization of the sound output from the acoustic device.

Moreover, when the acoustic device is in the mid-and-high frequency band, the resistor element connected in series may also reduce the current flowing through the piezoelectric component by voltage division, thereby reducing the heat produced by the piezoelectric component, achieving the effect of temperature control, and improving the operation reliability of the acoustic device.

## BRIEF DESCRIPTION OF THE DRAWINGS

The present disclosure is further illustrated in terms of exemplary embodiments. These exemplary embodiments are described in detail with reference to the drawings. These embodiments are non-limiting exemplary embodiments, in which like reference numerals represent similar structures, wherein:

FIG. 1 is a structural block diagram illustrating an exemplary acoustic device according to some embodiments of the present disclosure;

FIG. 2 is a schematic structural diagram illustrating an exemplary acoustic device according to some embodiments of the present disclosure;

FIG. 3 is a schematic circuit diagram illustrating an exemplary piezoelectric component according to some embodiments of the present disclosure;

FIG. 4 is a schematic diagram of an impedance-frequency curve of an exemplary piezoelectric component according to some embodiments of the present disclosure;

FIG. 5 is a schematic diagram illustrating a current-frequency curve of an exemplary piezoelectric component according to some embodiments of the present disclosure;

FIG. 6 is a schematic structural diagram illustrating an exemplary piezoelectric component according to some embodiments of the present disclosure;

FIG. 7 is a schematic circuit diagram illustrating an exemplary resistor element and an exemplary piezoelectric component according to some embodiments of the present disclosure;

FIG. 8 is a schematic diagram illustrating a voltage-frequency curve of an exemplary piezoelectric component according to some embodiments of the present disclosure;

FIG. 9 is a schematic diagram illustrating a frequency response curve of an exemplary vibration component according to some embodiments of the present disclosure;

FIG. 10 is a schematic diagram illustrating a current-frequency curve of an exemplary piezoelectric component according to some embodiments of the present disclosure;

FIG. 11A is a schematic diagram illustrating a connection structure of an exemplary piezoelectric component and an exemplary resistor element according to some embodiments of the present disclosure;

FIG. 11B is a schematic diagram illustrating a connection structure of an exemplary piezoelectric component and an exemplary resistor element according to some embodiments of the present disclosure;

FIG. 11C is a schematic diagram illustrating a connection structure of an exemplary piezoelectric component and an exemplary resistor element according to some embodiments of the present disclosure;

FIG. 11D is a schematic diagram illustrating a connection structure of an exemplary piezoelectric component and an exemplary resistor element according to some embodiments of the present disclosure;

FIG. 11E is a schematic diagram illustrating a connection structure of an exemplary piezoelectric component and an exemplary resistor element according to some embodiments of the present disclosure;

FIG. 11F is a schematic diagram illustrating a connection structure of an exemplary piezoelectric component and an exemplary resistor element according to some embodiments of the present disclosure;

FIG. 12 is a schematic structural diagram illustrating an exemplary circuit board according to some embodiments of the present disclosure;

FIG. 13A is a schematic diagram illustrating exemplary electrodes of a piezoelectric component according to some embodiments of the present disclosure;

FIG.13B is a schematic diagram illustrating exemplary electrodes of a piezoelectric component according to some embodiments of the present disclosure;

FIG. 13C is a schematic diagram illustrating exemplary electrodes of a piezoelectric component according to some embodiments of the present disclosure;

FIG. 13D is a schematic diagram illustrating exemplary electrodes of a piezoelectric component according to some embodiments of the present disclosure;

FIG. 13E is a schematic diagram illustrating exemplary electrodes of a piezoelectric component according to some embodiments of the present disclosure; and

FIG. 13F is a schematic diagram illustrating exemplary electrodes of a piezoelectric component according to some embodiments of the present disclosure.

## DETAILED DESCRIPTION

In order to more clearly illustrate the technical solutions related to the embodiments of the present disclosure, a brief introduction of the drawings referred to the description of the embodiments is provided below. Obviously, the drawings described below are only some examples or embodiments of the present disclosure. Those having ordinary skills in the art, without further creative efforts, may apply the present disclosure to other similar scenarios according to these drawings. Unless obviously obtained from the context or the context illustrates otherwise, the same numeral in the drawings refers to the same structure or operation.

It should be understood that the "system," "device," "unit," and/or "module" used herein are one method to distinguish different components, elements, parts, sections, or assemblies of different levels. However, if other words can achieve the same purpose, the words can be replaced by other expressions.

As used in the disclosure and the appended claims, the singular forms "a," "an," and "the" include plural referents unless the content clearly dictates otherwise; the plural forms may be intended to include singular forms as well. In general, the terms "comprise," "comprises," and/or "comprising," "include," "includes," and/or "including," merely prompt to include steps and elements that have been clearly identified, and these steps and elements do not constitute an exclusive listing. The methods or devices may also include other steps or elements.

The flowcharts used in the present disclosure illustrate operations that the system implements according to the embodiments of the present disclosure. It should be understood that the foregoing or following operations may not necessarily be performed exactly in order. Instead, the operations may be processed in reverse order or simultaneously. Besides, one or more other operations may be added to these processes, or one or more operations may be removed from these processes.

An acoustic device in one or more embodiments of the present disclosure may output sound through a vibration produced by a piezoelectric component, so as to be applied to various scenarios that need to play audio. For example, the acoustic device may be an independent audio output device (e.g., a stereo, an earphone, etc.) that is capable of playing an audio according to a user instruction. As another example, the acoustic device may be a module or component in a terminal device (e.g., a mobile phone, a computer, etc.) that is capable of playing an audio according to a terminal instruction. In some embodiments, the acoustic device may also adjust a deformation of the piezoelectric component to produce different vibrations according to parameters such as a frequency and a magnitude of the sound to be output, so that the vibration component may output different sounds according to different vibrations.

In some embodiments, the acoustic device may be a bone conduction acoustic device. The vibration component in the bone conduction acoustic device may fit to a user's body tissue to transmit sound waves produced by the vibration component to a user's inner ear through the user's bones. In some embodiments, the acoustic device may also be other types of acoustic devices, such as an air conduction acoustic device, a hearing aid, an audio aid, glasses, a helmet, an Augmented Reality (AR) device, a Virtual Reality (VR ) device, etc. Alternatively, the acoustic equipment may be used as a part of a vehicle audio system or a room audio system for outputting sound.

At present, the resonance frequency of the piezoelectric component in the acoustic device may usually be high, resulting in a high high-frequency sensitivity and a low low-frequency sensitivity of the device, thus the sound produced from the acoustic device may be harsh, and the user's sense of high-and-low frequency equalization may be poor.

The embodiments of the present disclosure provides an acoustic device. In some embodiments, the acoustic device may include a piezoelectric component, a vibration component, and a resistor element. The piezoelectric component may vibrate under an action of a driving voltage to produce a vibration. The vibration component may receive the vibration from the piezoelectric component and produce sound. The resistor element may be connected in series with the piezoelectric component to change a frequency response of the vibration component, so as to make a difference between a vibration amplitude of the vibration component at 10 kHz and a vibration amplitude of the vibration component at 1 kHz less than or equal to 20 db.

In the embodiments of the present disclosure, the resistor element and the piezoelectric component may be connected in series for voltage division, so that the voltage at both ends of the piezoelectric component may be reduced, the vibration amplitude of the vibration component in mid-and-high frequency bands may be reduced, a sensitivity difference of the full frequency band may be reduced, and high-and-low frequency equalization of the sound output from the acoustic device may be improved.

Moreover, when the acoustic device provided by the embodiments of the present disclosure is in the mid-and-high frequency band, the resistor element connected in series may also reduce a current flowing through the piezoelectric component according to the voltage division, thereby reducing the heat produced by the piezoelectric component, achieving the effect of temperature control, and improving the operation reliability of the acoustic device.

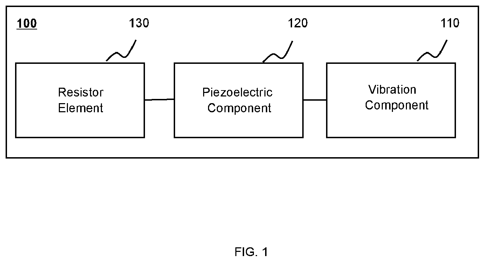

FIG. 1 is a structural block diagram illustrating an exemplary acoustic device 100 according to some embodiments of the present disclosure.

As shown in FIG. 1, the acoustic device 100 may include a vibration component 110, a piezoelectric component 120, and a resistor element 130. The piezoelectric component 120 may vibrate under an action of a driving voltage to produce a vibration. The vibration component 110 may be mechanically connected to the piezoelectric component 120 to receive the vibration and produce sound. The resistor element 130 may be connected in series with the piezoelectric component 120 to change a frequency response of the vibration component 110. The resistor element 130 may be configured that a difference between a vibration amplitude of the vibration component 110 at 10 kHz and a vibration amplitude of the vibration component 110 at 1 kHz is less than or equal to 20 dB.

The vibration component 110 may be configured as a component which transmits the vibration and produce the sound. In some embodiments, the vibration component 110 may include an elastic element. The elastic element may deform in response to the vibration to change a sound pressure around the elastic element, so as to produce sound waves and implement sound output. Exemplarily, the elastic element may change a density of the surrounding air through deformation (e.g., self-vibration, etc.) of the elastic element, forming sparse and dense longitudinal waves, thereby producing the sound waves. In some embodiments, the elastic element may include a vibration transmitting sheet, an adhesive, an elastic sheet, a substrate, etc., or any combination thereof. In some embodiments, the material of the elastic element may be any material capable of transmitting the vibration. For example, the material of the elastic element may be silicone, plastic, rubber, metal, etc., or any combination thereof. In some embodiments, the vibration component 110 may further include a mass element. One end of the elastic element may be connected with the piezoelectric component 120, and the other end of the elastic element may be connected with the mass element. In some embodiments, at least part of the piezoelectric component 120 may be connected with the elastic element, and part of the mass element may be connected with the elastic element. In some embodiments, the mass element may include a mass block, a housing, etc. For example, the housing may be configured to accommodate the piezoelectric component 120 and the resistor element 130 to protect the piezoelectric component 120 and the resistor element 130 and prolong the service life of the acoustic device 100. In some embodiments, the material of the housing may include one or more materials of metal, silica gel, rubber, plastic, etc., so as to achieve shock absorption. In some embodiments, the vibrating component 110 may be a membrane structure (e.g., an air conduction diaphragm, etc.), a plate structure (e.g., a bone conduction vibration panel, etc.), a mesh structure, a layered structure, or other structures.

An exemplary acoustic device 100 is provided below to describe an implementation of the vibration component 110.

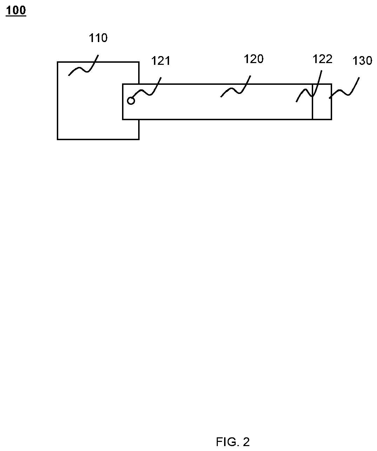

FIG. 2 is a schematic structural diagram illustrating an exemplary acoustic device 100 according to some embodiments of the present disclosure.

As shown in FIG. 2, one end of the vibration component 110 may be connected with a vibration output end 121 of the piezoelectric component 120 to receive the vibration. The other end of the vibration component 110 may output sound. Exemplarily, the vibration component 110 may send sound waves to a user through one or more media (e.g., air, user's bones, etc.), so that the user may hear the sound output from the acoustic device 100.

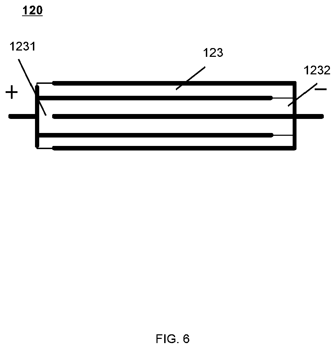

The piezoelectric component 120 may be configured as an electrical energy conversion device that converts electrical energy into mechanical energy. In some embodiments, the piezoelectric component 120 may deform to different degrees based on different driving voltages to produce vibrations. More descriptions regarding to the piezoelectric component 120 may be found in FIG. 6, FIGs. 11A-11F, FIG. 12, and FIGs. 13A-13F, and the descriptions thereof. In some embodiments, the piezoelectric component 120 may be in the shape of a sheet, a ring, a prism, a cuboid, a column, a ball, etc., or any combination thereof, or other irregular shapes. In some embodiments, the material of the piezoelectric component 120 may include a piezoelectric material such as a piezoelectric crystal, a piezoelectric ceramic, a piezoelectric polymer, or any combination thereof. In some embodiments, the piezoelectric crystal may include crystal, sphalerite, boracite, tourmaline, zincite, GaAs, barium titanate and its derivative structure crystals, $KH_2PO_4$, $NaKC_4H_4O_6 \cdot 4H_2O$ (Rochelle salt), etc., or any combination thereof. The piezoelectric ceramic may refer to a piezoelectric polycrystal formed by the random collection of fine grains obtained by solid-state reaction and sintering between different material powders. In some embodiments, the piezoelectric ceramic material may include barium titanate (BT), lead zirconate titanate (PZT), lead barium lithium niobate (PBLN), modified lead titanate (PT), aluminum nitride (AlN ), zinc oxide (ZnO), etc., or any combination thereof. In some embodiments, the piezoelectric polymer material may include polyvinylidene fluoride (PVDF), etc.

In some embodiments, the vibration amplitude of the piezoelectric component 120 may be adjusted by adjusting the magnitude of the driving voltage applied to the piezoelectric component 120. For example, the amplitude of the vibration output by the piezoelectric component 120 may be related to the magnitude of the applied voltage, and the relationship between the amplitude of the vibration output by the piezoelectric component 120 and the magnitude of the applied voltage may be expressed as formula (1):

$$F = \frac{d}{S^E} \cdot \frac{A}{t} \cdot V \quad (1),$$

where F denotes the amplitude of the vibration output by the piezoelectric component 120, V denotes the driving voltage of the piezoelectric component 120, d denotes a piezoelectric constant of the piezoelectric component 120, A denotes an area of the piezoelectric component 120, t denotes the thickness of the piezoelectric component 120, and $S^E$ denotes an elastic compliance constant of the piezoelectric component 120. According to formula (1), the amplitude of the vibration output by the piezoelectric component 120 may be proportional to the driving voltage of the piezoelectric component 120.

In some embodiments, a vibration frequency of the piezoelectric component 120 may also be adjusted by adjusting the frequency of the driving voltage applied to the piezoelectric component 120. In some embodiments, the vibration produced by the piezoelectric component 120 may also related to a piezoelectric constant of the piezoelectric material. For example, when the driving voltage is the same, the greater the piezoelectric constant is, the greater the deformation of the piezoelectric component 120 may be and the stronger the vibration may be. In some embodiments, different piezoelectric constants may lead to different deformation directions of the piezoelectric component 120. For example, the piezoelectric constant of the piezoelectric component 120 may be a D33 constant or a D31 constant, or other piezoelectric constants. The D33 constant may mean that an electrical direction (i.e., the direction of an electric field) and a mechanical direction (i.e., a deformation direction) of the piezoelectric component 120 may be the same. The D31 constant may mean that the deformation direction of the piezoelectric component 120 may mainly occur in one direction.

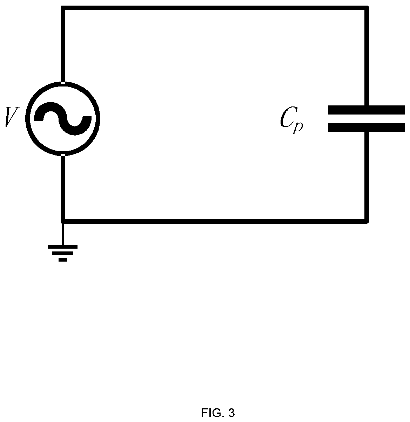

FIG. 3 is a schematic circuit diagram illustrating an exemplary piezoelectric component 120 according to some embodiments of the present disclosure.

In some embodiments, the piezoelectric component 120 may be regarded as a component with capacitive properties. As shown in FIG. 3, the piezoelectric component 120 may be a capacitor $C_p$ with a capacitance value. Correspondingly, an impedance $Z_p$ of the piezoelectric component 120 may be determined according to the formula (2):

$$Z_p = \frac{1}{j\omega C_p} \quad (2),$$

where $Z_p$ denotes an equivalent impedance value of the piezoelectric component 120, $\omega$ denotes an angular frequency of the driving voltage, and $C_p$ denotes an equivalent capacitance value of the piezoelectric component 120. According to formula (2), when the resistor element 130 is not arranged, the impedance $Z_p$ of the piezoelectric

component 120 may decrease as the angular frequency $\omega$ of the driving voltage increases.

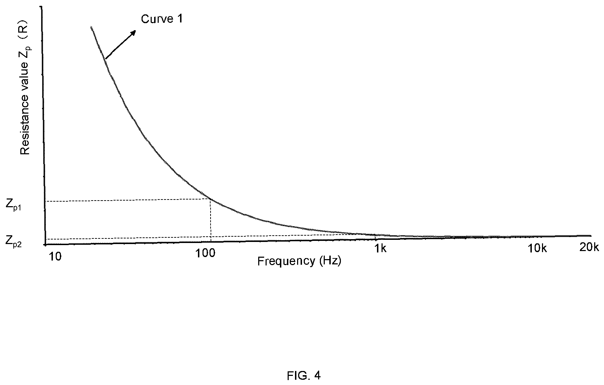

FIG. 4 is a schematic diagram illustrating an impedance-frequency curve of an exemplary piezoelectric component 120 according to some embodiments of the present disclosure.

As shown in FIG. 4, curve 1 may be an impedance-frequency curve of the piezoelectric component 120. According to the curve 1, as the frequency of the driving voltage increases (e.g., from 100 Hz to 1 kHz), the angular frequency $\omega$ of the driving voltage may also increase, and the impedance of the piezoelectric component 120 may decrease accordingly (e.g., from an impedance value $Z_{p1}$ down to an impedance value $Z_{p2}$).

Referring back to FIG. 3, when the resistor element 130 is not connected in series and the voltage V of the driving voltage remains unchanged, the decrease in the impedance $Z_p$ of the piezoelectric component 120 may lead to an increase in a current flowing through the piezoelectric component 120. That is to say, as the angular frequency $\omega$ of the driving voltage increases, the impedance $Z_p$ of the piezoelectric component 120 may decrease accordingly, thereby increasing the current flowing through the piezoelectric component 120.

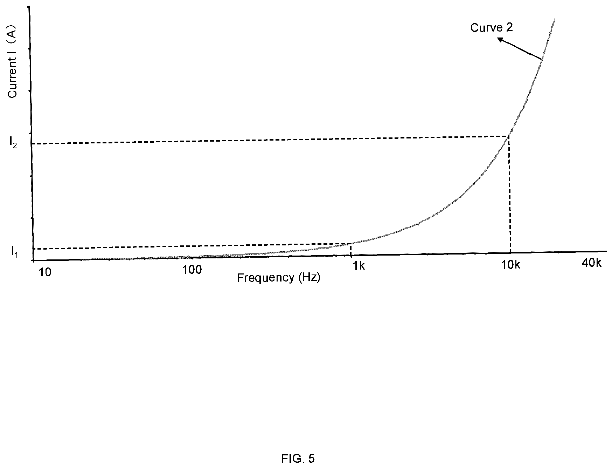

FIG. 5 is a schematic diagram illustrating a current-frequency curve of an exemplary piezoelectric component 120 according to some embodiments of the present disclosure.

As shown in FIG. 5, curve 2 may be a current-frequency curve of the piezoelectric component 120. According to the curve 2, as the frequency of the driving voltage increases (e.g., from 1 kHz to 10 kHz), the angular frequency $\omega$ of the driving voltage may also increase, and the current flowing through the piezoelectric component 120 may increase accordingly (e.g., from a current value $I_1$ up to a current value $I_2$). According to the Joule's law, i.e., formula (3), when the resistance is constant, the heating power P of an electronic device is proportional to the square of the current I,

$$P = I^2 R \quad (3),$$

therefore, when the resistor element 130 is not connected in series, as the frequency of the driving voltage increases, the current of the piezoelectric component 120 may increase accordingly, and the heating power of the piezoelectric component 120 may gradually increase at a mid-and-high frequency (e.g., greater than 1 kHz) of the driving voltage, resulting in a greater operation temperature of the piezoelectric component 120, which may be greater than the Curie temperature in a severe case, thus reducing the piezoelectricity of the piezoelectric component 120 and affecting the normal operation of the acoustic device 100.

In some embodiments, the piezoelectric component 120 may be a beam structure (e.g., a beam structure with one end fixedly connected to the acoustic device and one end freely vibrating may be regarded as a cantilever beam structure). In some embodiments, the fixed end of the piezoelectric component 120 of the cantilever beam structure (hereinafter referred to as the piezoelectric beam) may receive a voltage signal. The entire piezoelectric beam may vibrate, and transmit the vibration to the vibration component through any position on the piezoelectric beam (e.g., a free end) for the user's ear to perceive. The position where the vibration is output on the piezoelectric beam may be referred to as a vibration output end. In some embodiments, the vibration output end may directly output air conduction sound. In some embodiments, the vibration output end may be connected with the diaphragm to output the air conduction sound. In some embodiments, the vibration output end may be connected with a structure such as a vibration transmitting sheet to transmit the vibration to an auditory nerve through the user's skin, bones, or other tissues to output the bone conduction sound.

Exemplarily, as shown in FIG. 2, the fixed end of the cantilever beam structure may be a driving end 122 of the piezoelectric component 120. The driving end 122 may receive the driving voltage. The free end of the cantilever beam structure may be the vibration output end 121 of the piezoelectric component 120. The vibration output end 121 may produce and output the vibration.

In some embodiments, the piezoelectric component 120 may include at least two piezoelectric ceramic wafers. The at least two piezoelectric ceramic wafers may be electrically connected with each other. The piezoelectric ceramic wafers may be sheet-shaped component with piezoelectric properties. In some embodiments, the piezoelectric ceramic wafers may be mechanically deformed according to the magnitude and frequency of the driving voltage. For example, the piezoelectric ceramic wafers may extend when the driving voltage is positive and contract when the driving voltage is negative. In some embodiments, the polarization directions of different piezoelectric ceramic wafers may be different, so that the deformation directions produced under the same driving voltage may also be different. For example, when the driving voltage is positive, when the polarization directions of a piezoelectric ceramic wafer A and a piezoelectric ceramic wafer B are different, the piezoelectric ceramic wafer A may extend, while piezoelectric ceramic wafer B may contract. In some embodiments, the polarization directions of different piezoelectric ceramic wafers may also be the same, so that the deformation directions produced under the same driving voltage may also be the same.

In some embodiments, the piezoelectric component 120 may be a layered structure. In some embodiments, the at least two piezoelectric ceramic wafers may be laminated. For example, a plurality of piezoelectric ceramic wafers may be arranged overlappingly, and the positions of the plurality of piezoelectric ceramic wafers may correspond in space. In some embodiments, the vibration of the piezoelectric component 120 may be related to the number of layers of the piezoelectric ceramic wafers. Exemplarily, the more layers of the piezoelectric ceramic wafers is, the greater the vibration amplitude of the piezoelectric component 120 may be.

In some embodiments, the electrical interconnection of the at least two piezoelectric ceramic wafers may be related to the polarization directions between the piezoelectric ceramic wafers. For example, when the polarization directions of the piezoelectric ceramic wafers of different layers are in the same direction, the plurality of piezoelectric ceramic wafers may be connected in series, so that the deformation directions of different piezoelectric ceramic wafers may be different. As another example, the two piezoelectric ceramic wafers with the same polarization direction may be laminated and connected in series, and the driving voltages of the two layers of piezoelectric ceramic wafers may be reversed, resulting in the reversed deformation directions of the two layers of piezoelectric ceramic wafers, thereby increasing the deformation strength of the piezoelectric component 120, and further increasing the vibration amplitude of the piezoelectric component 120.

In some embodiments, when the polarization directions of piezoelectric ceramic wafers of different layers are reversed, the plurality of piezoelectric ceramic wafers may be connected in parallel, so that the deformation directions of different piezoelectric ceramic wafers may be different. For example, the two piezoelectric ceramic wafers with opposite polarization directions may be laminated and connected in parallel, and the driving voltages of the two piezoelectric ceramic wafers are reversed, resulting in the reversed deformation directions of the two layers of piezoelectric ceramic wafers, thereby increasing the deformation strength of the piezoelectric component 120, and further increasing the vibration amplitude of the piezoelectric component 120. An exemplary piezoelectric component 120 may be provided below to describe an implementation of the piezoelectric ceramic wafers connected in parallel.

FIG. 6 is a schematic structural diagram illustrating an exemplary piezoelectric component 120 according to some embodiments of the present disclosure.

As shown in FIG. 6, the piezoelectric component 120 may include a plurality of piezoelectric ceramic wafers 123. The plurality of piezoelectric ceramic wafers 123 may be laminated. In some embodiments, the plurality of piezoelectric ceramic wafers 123 may be respectively disposed in a first layer, a second layer, a third layer, and a fourth layer of the piezoelectric component 120. Polarity directions of the piezoelectric ceramic wafers 123 in the first layer and the second layer may be different from the polarity directions of the piezoelectric ceramic wafers 123 in the third layer and the fourth layer (i.e., the polarity directions of the first layer and the second layer may be same, and the polarity directions of the third layer and the fourth layer may be the same). When a driving voltage is applied to the piezoelectric component 120, deformation directions of the first layer and the second layer may be opposite to deformation directions of the third layer and the fourth layer, so as to increase a vibration amplitude of the piezoelectric component 120.

In some embodiments, positive and negative electrodes may be respectively arranged at both ends of the at least two piezoelectric ceramic wafers, so that the at least two piezoelectric ceramic wafers may be connected in parallel to provide the same driving voltage for the piezoelectric ceramic wafers. In some embodiments, the at least two piezoelectric ceramic wafers may be interleaved with electrodes of the piezoelectric component 120. The positive and negative electrodes of the piezoelectric component 120 may extend to a position between the plurality of piezoelectric ceramic wafers, thereby increasing an area in contact with the piezoelectric ceramic wafers and improving driving efficiency.

Exemplarily, as shown in FIG. 6, the positive electrode may be in contact with first ends 1231 of the plurality of piezoelectric ceramic wafers 123, and the negative electrode may be in contact with second ends 1232 of the plurality of piezoelectric ceramic wafers 123, so as to implement parallel connection of the plurality of piezoelectric ceramic wafers 123. The positive electrode may also be disposed between the first layer and the second layer of the plurality of piezoelectric ceramic wafers 123, and disposed between the third layer and the fourth layer of the plurality of piezoelectric ceramic wafers 123. The negative electrode may be disposed on surfaces of the plurality of piezoelectric ceramic wafers 123, and disposed between the second layer and the third layer of the plurality of piezoelectric ceramic wafers 123.

In the embodiments of the present disclosure, the acoustic device 100 may produce vibrations to radiate sound waves outward through the inverse piezoelectric effect of the piezoelectric component 120. Compared with a transmission electric speaker, the acoustic device 100 may have advantages of high electro-mechanical conversion efficiency, low energy consumption, small volume, and high degree of integration. It should be noted that FIG. 3 is only an example, and the piezoelectric component 120 may also include other counts of piezoelectric ceramic wafers, or be connected with the electrodes in other forms.

The resistor element 130 may be configured as any electrical device which has resistance properties or achieves a band-pass regulation effect. For example, the resistor element 130 may include a component, a material, a coating, an adhesives with the resistance properties, etc., or any combination thereof. As another example, the resistor element 130 may also include a resistance-capacitance (RC) filter with the band-pass regulation effect, such as an RC filter in series configuration, an RC filter in parallel configuration, an RC filter in series-parallel configuration, cascaded or multi-order RC filters, a passive or active RC filter, etc., or any combination thereof.

In some embodiments, the resistor element 130 may be connected in series with the piezoelectric component 120 to adjust an amplitude difference of the vibration component 110. For example, the resistor element 130 may regulate a voltage or bandwidth at both ends of the piezoelectric component 120 through the principle of series voltage division, so that the amplitude difference of the vibration component 110 at high-and-low frequencies may change.

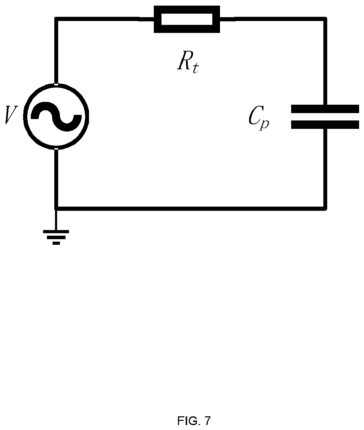

FIG. 7 is a schematic circuit diagram illustrating an exemplary resistor element 130 and an exemplary piezoelectric component 120 according to some embodiments of the present disclosure.

As shown in FIG. 7, the resistor element 130 may be equivalent to a resistor Rt, the piezoelectric component 120 may be equivalent to a capacitor $C_p$, the resistor $R_t$ may be connected in series with the capacitor $C_p$, and a driving voltage V provides the voltage for both the resistor $R_t$ and the capacitor $C_p$. When the voltage of the driving voltage V is constant and the frequency of the driving voltage V is continuously increasing, the voltage at both ends of the resistor element 130 may increase due to the decrease in impedance of the piezoelectric component 120, and the voltage at both ends of the piezoelectric component 120 may decrease.

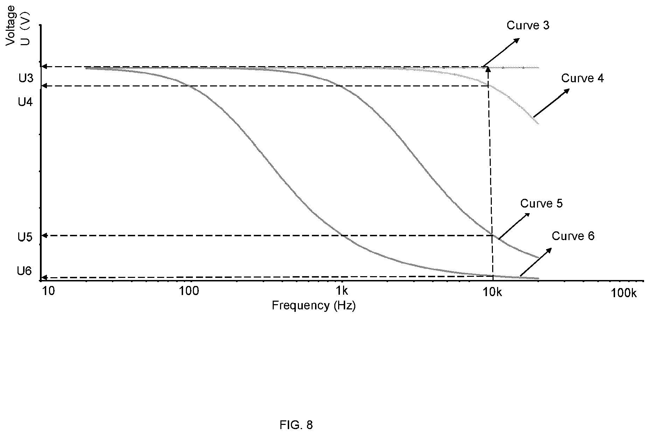

FIG. 8 is a schematic diagram illustrating a voltage-frequency curve of an exemplary piezoelectric component 120 according to some embodiments of the present disclosure.

In some embodiments, the voltage at both ends of the piezoelectric component 120 may be adjusted by adjusting the resistance value of the resistor element 130. As shown in FIG. 8, curve 3 may be a voltage-frequency curve of the piezoelectric component 120 when the resistor element 130 is not connected in series (i.e., the resistor element 130 with the resistance value $R_1=0$ may be connected in series). C curve 4 may be a voltage-frequency curve of the piezoelectric component 120 when the resistor element 130 with the resistance value $R_2$ is connected in series. Curve 5 may be a voltage-frequency curve of the piezoelectric component 120 when the resistor element 130 with the resistance value $R_3$ is connected in series. Curve 6 may be a voltage-frequency curve of the piezoelectric component 120 when the resistor element 130 with the resistance value $R_4$ is connected in series, where $0=R_1<R_2<R_3<R_4$.

In some embodiments, when the frequency of the driving voltage V is low (e.g., 10 Hz-100 Hz), as the impedance of the piezoelectric component 120 is relatively great, the resistor element 130 connected in series may have no obvious effect on the overall impedance and have little effect on the voltage of the piezoelectric component. When the frequency of the driving voltage V gradually increases to a medium-and-high frequency (e.g. a frequency of 1 kHz-10 kHz), the voltage at both ends of the piezoelectric component 120 may decrease. For example, when the frequency of the driving voltage V increases to 10 kHz, the voltage of the piezoelectric component 120 in the curve 3 may be U3, the voltage of the piezoelectric component 120 in curve 4 may be

**EP 4 266 700 A1**

$U_4$, the voltage of the piezoelectric component 120 in the curve 5 may be $U_5$, and the voltage of the piezoelectric component 120 in the curve 6 may be U6, where $U_3>U_4>U_5>U_6$.

In some embodiments, as the resistance value of the resistor element 130 increases, a frequency point at which the voltage at both ends of the piezoelectric component 120 begins to decrease may increase gradually. As shown in curves 2-4 in FIG. 8, as the resistance value of the resistor element increases, the frequency point at which the voltage begins to decrease may increase gradually. Correspondingly, in some embodiments, the acoustic output properties of the acoustic device 100 may be regulated by adjusting the resistance value of the resistor element 130, so as to meet the requirements for the frequency response characteristics and applications of the acoustic device 100.

In some embodiments, the resistor element 130 may be connected in series with the piezoelectric component 120 to regulate the voltage at both ends of the piezoelectric component 120 or the bandwidth of the piezoelectric component 120 to change the frequency response of the vibration component 110. In some embodiments, the resistor element 130 may be connected in series with the piezoelectric component 120 to adjust the voltage at both ends of the piezoelectric component 120, so that the amplitude difference of the vibration component 110 at high-and-low frequencies may change. An exemplary frequency response curve of the vibration component 110 may be provided below to describe an implementation of the resistor element 130.

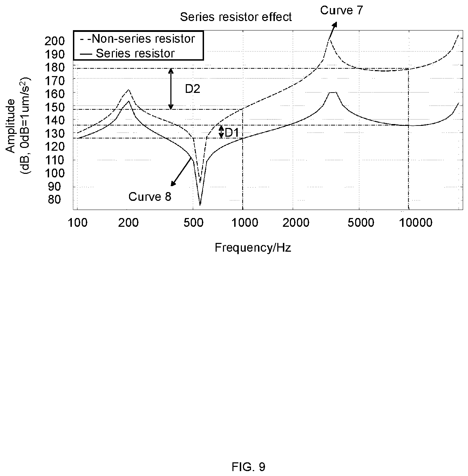

FIG. 9 is a schematic diagram illustrating a frequency response curve of a vibration component according to some embodiments of the present disclosure. As shown in FIG 9, curve 7 may be frequency response curve of the vibration component 110 when the piezoelectric component 120 is not connected in series with the resistor element 130, and curve 8 may be frequency response curve of the vibration component 110 when the piezoelectric component 120 is connected in series with the resistor element 130. In some embodiments, the series resistor element 130 may act to suppress a high frequency output. For example, as shown in FIG 9, when the resistor element 130 is connected in series, a peak-valley position of the frequency response curve may not change, and the amplitude of the low frequency may not be greatly affected. However, starting from a certain frequency (e.g., 600 Hz), as the frequency increases, the more the amplitude of the corresponding frequency decreases, the less the difference between the amplitudes of high and low frequency curves may be, the subjective sense of hearing "harshness" may be alleviated, and the sense of equalization of high-and-low frequencies may be improved. As shown in FIG. 9, a difference D2 between the amplitude at 10 kHz and the amplitude at 1 kHz of the curve 8 may be less than a difference D1 between the amplitude at 10 kHz and the amplitude at 1 kHz of the curve 7. In some embodiments, the difference D2 may be less than or equal to a certain threshold (e.g., 30 dB, 20 dB, 15 dB, etc.). In the embodiments of the present disclosure, the resistor element 130 and the piezoelectric component 120 may be connected in series, so that the acoustic device 100 may have a less sensitivity difference of the full frequency band, thereby improving the high-and-low frequency equalization of the sound output from the acoustic device 100.

In some embodiments, when the voltage of the driving voltage V is constant and the frequency of the driving voltage V is continuously increasing, the resistor element 130 connected in series may cause the voltage at both ends of the piezoelectric component 120 to decrease due to a decrease of the impedance of the piezoelectric component 120, and the current flowing through the piezoelectric component 120 may decrease accordingly. Moreover, according to Joule's law (formula (3)), the heating power of the piezoelectric component 120 is proportional to the square of the current. Compared with the case where the resistor element 130 is not connected in series, the heating of the piezoelectric component 120 may also be reduced accordingly, thereby improving device reliability.

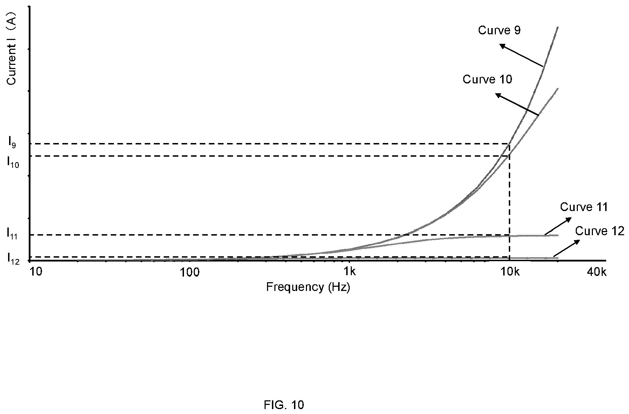

FIG. 10 is a schematic diagram illustrating a current-frequency curve of an exemplary piezoelectric component 120 according to some embodiments of the present disclosure.

In some embodiments, the current flowing through the piezoelectric component 120 may be adjusted by adjusting the resistance value of the resistor element 130, thereby adjusting the heating of the piezoelectric component 120 to implement temperature control. As shown in FIG. 9, curve 9 may be a current-frequency curve of the piezoelectric component 120 when the resistor element 130 is not connected in series (i.e., the resistor element 130 with the resistance value $R_9=0$ may be connected in series); curve 10 may be a current-frequency curve of the piezoelectric component 120 when the resistor element 130 with a resistance value of $R_{10}$ is connected, curve 11 may be a current-frequency curve of the piezoelectric component 120 when the resistor element 130 with a resistance value of $R_{11}$ is connected; and a curve 12 may be a current-frequency curve of the piezoelectric component 120 when the resistor element 130 with a resistance value of $R_{12}$ is connected, where $0=R_9<R_{10}<R_{11}<R_{12}$.

When the frequency of the driving voltage V is low (e.g., 10-100 Hz), due to the great impedance of the piezoelectric component 120, the series resistor element 130 may have no obvious effect on the overall impedance and have little effect on the current flowing through the piezoelectric component 120. When the frequency of the driving voltage V gradually increases to a mid-and-high frequency (e.g., a frequency of 1 kHz-10 kHz), the current flowing through the piezoelectric component 120 may decrease. Moreover, at the same frequency of the driving voltage, as the resistance value of the resistor element 130 increases, the current flowing through the piezoelectric component 120 may decrease. For example, when the frequency of the driving voltage V increases to 10 kHz, the current of the piezoelectric component 120 in the curve 9 may be $I_9$, the current of the piezoelectric component 120 in the curve 10 may be $I_{10}$, the voltage of the piezoelectric component 120 in the curve 11 may be $I_{11}$, and the current of the piezoelectric component 120 in the curve 12 may be $I_{12}$, where, $I_9 > I_{10} > I_{11} > I_{12}$.

In some embodiments, the magnitude of the series resistor may be determined according to the overall frequency response characteristics of the formed acoustic device 100. For example, according to the characteristics of the piezoelectric component 120, assuming that the high-frequency amplitude is relatively great or tends to increase, the magnitude of the resistor element 130 to be connected in series may be determined in combination with subjective listening. For example, it may be determined that from a certain frequency threshold fc, the effect that the greater the frequency is, the more the corresponding amplitude decreases as the frequency increases may be achieved according to the frequency response curve of the piezoelectric component 120. In some embodiments, the frequency threshold fc may be determined according to specific vibration characteristics of the piezoelectric component 120.

In some embodiments, an electrostatic capacitance of a piezoelectric plate of the piezoelectric component 120 may be determined according to formula (4):

$$C_p = \frac{\varepsilon S}{t} \ (4),$$

where, ε denotes a dielectric constant of the piezoelectric plate, S denotes an electrode area, and t denotes a distance between the positive and negative electrodes. Assuming that the dielectric constant ε is changed by changing the piezoelectric material, the electrostatic capacitance may be changed, and the resistance may need to be re-matched according to formula (5). If the geometric dimensions S and t of the electrodes are changed, the vibration characteristics of the acoustic device 100 may be affected, and the specific value of the series resistor may be judged according to the frequency response curve in combination with subjective listening.

For the acoustic device 100 constructed from piezoelectric plates $C_{p1}$ and $C_{p2}$ with different capacitance values, assuming that both of the two acoustic devices need to achieve the effect that the frequency response amplitude decreases with the increase of frequency from the frequency threshold fc, resistor elements $R_1$ and $R_2$ which need to be connected in series may be determined according to formula (5):

$$f_c = \frac{1}{2\pi R_1 C_{p1}} = \frac{1}{2\pi R_2 C_{p2}} \ (5).$$

In some embodiments, the resistance value of the resistor element 130 may be within a certain range (e.g., 1 Ω-1000 Ω, 100 Ω-10 kΩ, etc.), so that the vibration amplitude of the vibration component 110 may start to decrease at the frequency threshold fc (e.g., 100 Hz), the difference between the amplitude of the vibration component 110 at 10 kHz and the amplitude of the vibration component 110 at 1kHz may be less than or equal to 20 dB, then the acoustic device 100 may have a less sensitivity difference in the full frequency band, thereby improving the high-and-low frequency equalization of the sound output from the acoustic device 100. Meanwhile, the resistor element 130 may also reduce the heating of the piezoelectric component 120, so that the operation temperature of the piezoelectric component 120 may be lower than the Curie temperature, ensuring the normal operation of the acoustic device 100. For example, under a single frequency excitation of 6 kHz, the surface temperature (e.g., 236.9° C.) of the piezoelectric component 120 not connected in series may be relatively high, which may be close to the Curie temperature (e.g., the Curie temperature of the piezoelectric component 120 may be 290°C) of the piezoelectric component 120. When the excitation time increases, the surface temperature of the piezoelectric component 120 may exceed the Curie temperature of the piezoelectric component 120, causing the piezoelectric component to fail. However, under the excitation of a 6 kHz single frequency signal, the surface temperature of the piezoelectric component 120 connected in series with the resistor element 130 may decrease significantly. For example, the surface temperature of the piezoelectric component 120 may be lower than the Curie temperature of the piezoelectric component 120 within 5 minutes of excitation of the 6 kHz single frequency signal.

In some embodiments, the resistor element 130 may be connected in series with the piezoelectric component 120 in different ways. Taking the above-mentioned piezoelectric component in FIG. 6 as an example, several exemplary connection relationships between the resistor element 130 and the piezoelectric component 120 may be provided below to describe the implementation of the resistor element 130 in detail.

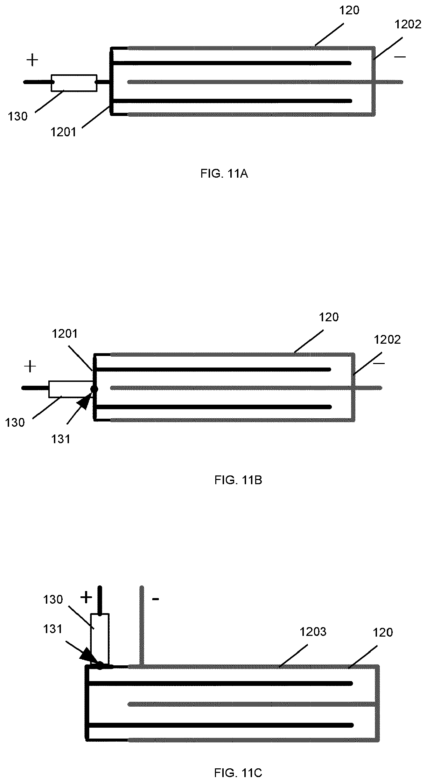

FIGs. 11A-11F are schematic diagrams illustrating connection structures of an exemplary piezoelectric component 120 and an exemplary resistor element 130 according to some embodiments of the present disclosure.

In some embodiments, the resistor element 130 may be connected to the electrodes of the piezoelectric component 120. In some optional embodiments, as shown in FIGs. 11A-11C, the resistor element 130 may be connected in series with a positive electrode of the piezoelectric component 120. Correspondingly, a driving voltage may be applied to both ends of a whole formed by the resistor element 130 and the piezoelectric component 120.

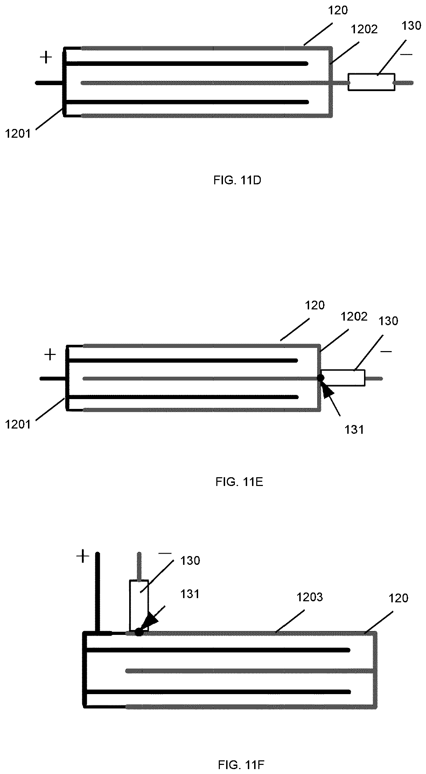

In some optional embodiments, as shown in FIGs. 11D-11F, the resistor element 130 may also be connected in series with a negative electrode of the piezoelectric component 120. Correspondingly, the driving voltage may be applied to both ends of the whole formed by the piezoelectric component 120 and the resistor element 130. In some embodiments, there may be a plurality of resistor elements 130, and the plurality of resistor elements 130 may be respectively connected in series with the positive electrode or the negative electrode of the piezoelectric component 120. For example, one or more of the plurality of resistor elements 130 may be connected in series with the positive electrode of the piezoelectric component 120, and the remaining resistor elements 130 may be connected in series with the negative electrode of the piezoelectric component 120. As another example, the plurality of resistor elements 130 may all be connected in series with the positive electrode or the negative electrode of the piezoelectric component 120.

In some embodiments, the resistor element 130 may be connected with the electrodes of the piezoelectric component 120 through leads. As shown in FIG. 11A, one end of the resistor element 130 may be connected with the positive electrode of the piezoelectric component 120 through a lead, and the other end of the resistor element 130 may receive the driving voltage. As shown in FIG. 11D, one end of the resistor element 130 may be connected with the negative electrode of the piezoelectric component 120 through a lead, and the other end of the resistor element 130 may receive the driving voltage.

In some embodiments, the resistor element 130 may be welded on the electrodes of the piezoelectric component 120. In some embodiments, the resistor element 130 may be welded on the positive electrode of the piezoelectric component 120. As shown in FIG. 11B-FIG. 11C, one end of the resistor element 130 (e.g., a solder point shown in the figure) may be welded on the positive electrode of the piezoelectric component 120 through a conductive adhesive 131 and electrically connected with the piezoelectric component 120. Correspondingly, the driving voltage may be applied to both ends of the whole formed by the resistor element 130 and the piezoelectric component 120.

In some embodiments, the resistor element 130 may also be welded on the negative electrode of the piezoelectric component 120. As shown in FIGs. 11E-11F, one end of the resistor element 130 may be welded on the negative electrode of the piezoelectric component 120 through the conductive adhesive 131 and electrically connected with the piezoelectric component 120. Correspondingly, the driving voltage may be applied to both ends of the whole formed by the piezoelectric component 120 and the resistor element 130.

In some embodiments, the positive electrode and the negative electrode of the piezoelectric component 120 may be led out of different sides of the piezoelectric component 120 to apply the driving voltage to the piezoelectric component 120 and the resistor element 130. As shown in FIGs 11A-11B and FIGs 11D-11E, the positive electrode of the piezoelectric component 120 may be led out of a first side 1201 of the piezoelectric component 120, and the negative electrode of the piezoelectric component 120 may be led out of a second side 1202 of the piezoelectric component 120.

In some embodiments, the positive electrode and the negative electrode of the piezoelectric component 120 may be led out from a same side of the piezoelectric component 120 to save space occupied by the piezoelectric component 120 and the resistor element 130. As shown in FIG. 11C and FIG. 11F, both the positive electrode and the negative electrode of the piezoelectric component 120 may be led out from a third side 1203 of the piezoelectric component 120.

In some embodiments, the resistor element 130 may include one or more resistors connected in series with the piezoelectric component 120. In some embodiments, a size of the resistor element 130 may be adjusted by adjusting the number and/or resistance value of resistors.

In some embodiments, the resistor element 130 may include leads connected with the piezoelectric component 120. The leads may be circuit devices for electrically connecting the piezoelectric component 120 with other devices. As shown in FIG. 11A and FIG. 11D, the leads may be used to connect the resistor element 130 with the piezoelectric component 120. In some embodiments, the leads may include one or a combination of more of a lead between the piezoelectric component 120 and the driving voltage, leads between the piezoelectric component 120 and the resistors, and leads between the piezoelectric component 120 and other devices.

In some embodiments, the resistance value of the resistor element 130 may be adjusted by adjusting the resistance values of the leads. For example, the resistance values of the leads may be adjusted by adjusting the configurations of the leads, such as a cross-sectional area, a length, and a detour shape of the leads, so as to adjust the resistance value of the resistor element 130.

In some embodiments, the resistor element 130 may include a conductive adhesive connected with the piezoelectric component 120. The conductive adhesive may be a circuit device for electrically connecting the piezoelectric component 120 with other devices. As shown in FIG. 11B, FIG. 11C, FIG. 11E or FIG. 11F, the conductive adhesive may be used to connect the resistor element 130 with the piezoelectric component 120. In some embodiments, the material of the conductive adhesive may include one or a combination of metals (e.g., gold, silver, copper, aluminum, zinc, iron, and nickel), graphite, epoxy resin, acrylic resin, and polyurethane. The material of the conductive adhesive may also include other conductive compounds. In some embodiments, the resistance value of the conductive adhesive may be adjusted by adjusting the material and amount of the conductive adhesive, so as to adjust the resistance value of the resistor element 130.

In some embodiments, the resistor element 130 may include one or a combination of more resistors, leads connected with the piezoelectric component 120, and the conductive adhesive connected with the piezoelectric component 120, or other devices with resistance properties. In some embodiments, the overall resistance value of the resistor element 130 may be adjusted by adjusting the resistance value of one or more devices in the resistor element 130.

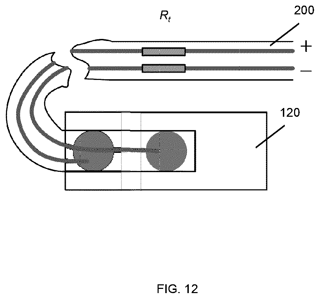

FIG. 12 is a schematic structural diagram illustrating an exemplary circuit board according to some embodiments of the present disclosure.

In some embodiments, the resistor element 130 may be arranged on a flexible printed circuit (FPC) to save the volume of the acoustic device 100. As shown in FIG. 12, two resistors $R_t$ may be respectively connected with positive and negative electrodes of the piezoelectric component 120, and arranged on leads led out of the electrodes of the piezoelectric component 120 in a flexible printed circuit 200. The resistor element 130 may include the resistors Rt, the leads, and a conductive adhesive. The resistance value of the resistor element 130 may be determined according to the resistance values of the resistors Rt, the configurations of the leads (e.g., a cross-sectional area, a length, a detour shape, etc.), and the resistance value of the conductive adhesive.

In some embodiments, the resistor element 130 may include electrodes of the piezoelectric component 120. For the arrangement relationship between the positive and negative electrodes of the piezoelectric component 120 and the piezoelectric component 120, please refer to the related descriptions of FIG. 6.

In some embodiments, as the electrodes may also have certain resistance properties, the overall resistance value of the resistor element 130 may be adjusted by adjusting the resistance values of the electrodes of the piezoelectric component 120. The resistance value of an electrode may be determined according to formula (6):

$$R_p = \frac{\rho L}{S} \ (6),$$

where $R_p$ denotes the resistance value of the electrode, $\rho$ denotes resistivity of the electrode, L denotes a length of the electrode, and S denotes a cross-sectional area of the electrode. In some embodiments, the resistance values of the electrode may be adjusted by adjusting the material, shape, length, and other parameters of the electrodes.

In some embodiments, at least part of the electrode of the piezoelectric component 120 may be made of one of the following materials: copper, gold, aluminum, tungsten, iron, or platinum, or other materials with suitable resistivity. For example, part of the material of the electrode of the piezoelectric component 120 may be changed from silver to copper, so that the resistivity may change, and the resistance values of the electrode may also change accordingly, thereby adjusting the resistance value of the resistor element 130.

In some embodiments, an effective cross-sectional area of at least part of the electrode of the piezoelectric component 120 may be less than a contour cross-sectional area of the electrode to increase the resistance value of the resistor element 130, thereby adjusting the voltage and heating power of the piezoelectric component 120. The effective cross-sectional area of the electrode may be a cross-sectional area actually used when the electrode are operating, and the contour cross-sectional area may be a cross-sectional area formed by lines at the outermost edge of the electrode. In some embodiments, by controlling the effective cross-sectional area of at least part of the electrode to be less than the contour cross-sectional area, the resistance value of the electrode may be increased, thereby adjusting the resistance value of the resistor element 130. In some embodiments, by adjusting an effective cross-sectional shape of the electrode, such as controlling the cross-section of the electrode to be in a shape of a mesh (e.g., the shape of the mesh may be a triangle, a quadrilateral, a polygon, a circle, an ellipse, or other irregular shapes), the effective cross-sectional area of the electrode may be reduced.

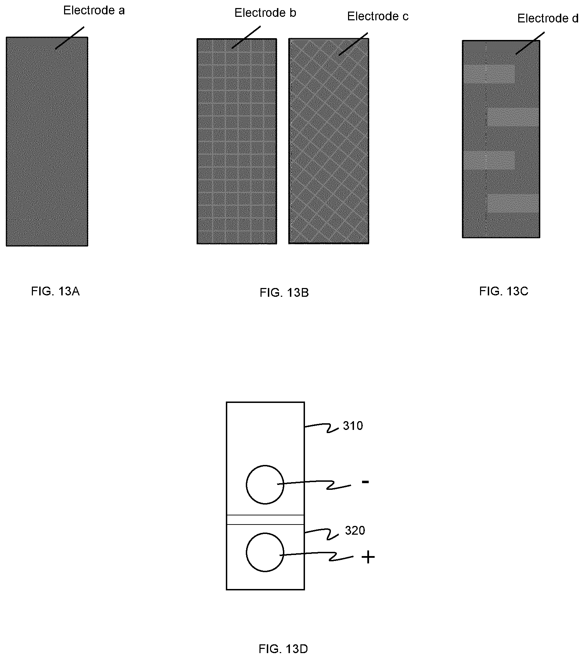

FIGs. 13A-13F are schematic diagrams illustrating exemplary electrodes of a piezoelectric component according to some embodiments of the present disclosure.

In some embodiments, a cross section of at least part of the electrode of the piezoelectric component 120 may be a mesh structure or an S-shaped structure. As shown in FIG. 13A-FIG. 13C, an electrode a may be an original rectangular electrode, an electrode b and an electrode c may be mesh electrodes, and an electrode d may be an S-shaped electrode. The effective cross-sectional area may be an area of a shaded part, and the contour cross-sectional area may be a rectangular area. That is to say, the effective cross-sectional area of the electrode a may be equal to the contour cross-sectional area of the electrode. The effective cross-sectional area of the electrode b and the effective cross-sectional area of the electrode c may be in the shape of the mesh, so that the effective cross-sectional area may be less than the contour cross-sectional area. The effective cross-sectional area of an electrode d may be S-shaped, so that the effective cross-sectional area may be less than the contour cross-sectional area. Accordingly, under the conditions of the same material and the same length, the resistance value of the electrode d may be greater than the resistance value of the electrode b and the resistance value of the electrode c, and the resistance value of the electrode b and the resistance value of the electrode c may be greater than the resistance value of the electrode a.

In some embodiments, a partial cross-sectional area of the electrode of the piezoelectric component 120 may be changed to change the resistance value of the electrode. For example, as shown in FIG. 13D, a cross-sectional area of lead-out sections of rectangular electrodes 310 and 320 may be reduced to a circular shape to change the resistance values of the electrodes, thereby changing the resistance value of the resistor element 130.

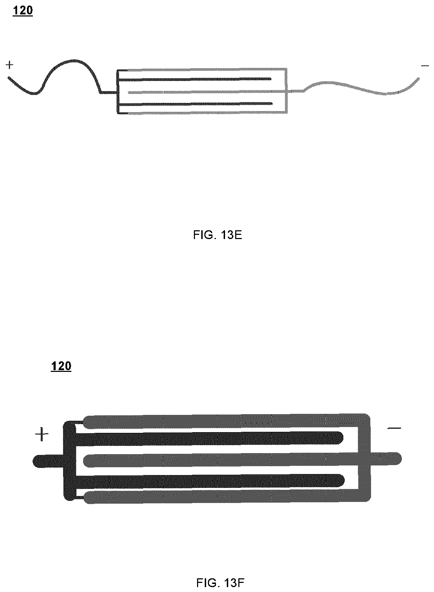

In some embodiments, the resistance values of the electrode of the piezoelectric component 120 may also be adjusted by changing the length of the electrode, thereby adjusting the resistance value of the resistor element 130. As shown in FIG. 13E, lengths of lead-out sections of positive and negative electrodes of the piezoelectric component 120 may be increased, thereby increasing the resistance values of the electrodes, and further increasing the resistance value of the resistor element 130.

In some embodiments, the resistance value of the electrode of the piezoelectric component 120 may also be adjusted by changing a thickness of the electrode, thereby adjusting the resistance value of the resistor element 130. As shown in FIG. 13F, compared with the electrode thickness of the piezoelectric component 120 in FIG. 6, the electrode thickness of the piezoelectric component 120 in FIG. 13 may be increased, thereby increasing the resistance value of the electrode, and further increasing the resistance value of the resistor element 130.

In some embodiments, the acoustic device 100 may be a bone conduction acoustic device. Correspondingly, the vibration component 110 may be fit to a user's human tissue. The sound waves emitted by the vibration component 110 may be transmitted to the inner ear of the user through the user's bones, so as to realize sound transmission. In some embodiments, the acoustic device 100 may also include a boost electrical system. The boost electrical system may be configured to increase a voltage output by a power supply (e.g., a battery).

In some embodiments, the acoustic device 100 may further include: a connecting piece configured to connect the housing with the human body. In some embodiments, the connecting piece may be a wearable device for fitting the housing to the user. Exemplarily, the connecting piece may be a spectacle frame. The housing may be arranged at glasses legs of the spectacle frame. When the user wears the spectacle frame, the housing may be in contact with the human body, so that the acoustic device 100 may transmit sound to the user. As another example, the connecting piece may be a headband. The housing may be arranged at one end of the headband. When the user wears the headband, the housing may be in contact with the human body, so that the acoustic device 100 may transmit sound to the user.

The possible beneficial effects of the embodiments of the present disclosure include but are not limited to: (1) by setting the resistor element connected in series with the piezoelectric component for voltage division, the voltage at both ends of the piezoelectric component may be reduced, thereby reducing the vibration component of the vibration component in the mid-and-high frequency band, reducing the sensitivity difference of the full frequency band, and improving the high-and-low frequency equalization of the sound output from the acoustic equipment. (2) When the acoustic device is in the mid-and-high frequency bands, the resistor element connected in series may also reduce the current flowing through the piezoelectric component by voltage division, thereby reducing the heat energy produced by the piezoelectric component, achieving the effect of temperature control, and improving the operation reliability of the acoustic device.

Having thus described the basic concepts, it may be rather apparent to those skilled in the art after reading this detailed disclosure that the foregoing detailed disclosure is intended to be presented by way of example only and is not limiting. Although not explicitly stated here, those skilled in the art may make various modifications, improvements and amendments to the present disclosure. These alterations, improvements, and modifications are intended to be suggested by this disclosure, and are within the spirit and scope of the exemplary embodiments of this disclosure.

Moreover, certain terminology has been used to describe embodiments of the present disclosure. For example, the terms "one embodiment," "an embodiment," and/or "some embodiments" mean that a particular feature, structure or characteristic described in connection with the embodiment is included in at least one embodiment of the present disclosure. Therefore, it is emphasized and should be appreciated that two or more references to "an embodiment" or "one embodiment" or "an alternative embodiment" in various parts of this specification are not necessarily all referring to the same embodiment. In addition, some features, structures, or features in the present disclosure of one or more embodiments may be appropriately combined.

Furthermore, the recited order of processing elements or sequences, or the use of numbers, letters, or other designations therefore, is not intended to limit the claimed processes and methods to any order except as may be specified in the claims. Although the above disclosure discusses through various examples what is currently considered to be a variety of useful embodiments of the disclosure, it is to be understood that such detail is solely for that purpose, and that the appended claims are not limited to the disclosed embodiments, but, on the contrary, are intended to cover modifications and equivalent arrangements that are within the spirit and scope of the disclosed embodiments. For example, although the implementation of various components described above may be embodied in a hardware device, it may also be implemented as a software only solution, e.g., an installation on an existing server or mobile device.

Similarly, it should be appreciated that in the foregoing description of embodiments of the present disclosure, various features are sometimes grouped together in a single embodiment, figure, or description thereof for the purpose of streamlining the disclosure aiding in the understanding of one or more of the various embodiments. However, this disclosure does not mean that the present disclosure object requires more features than the features mentioned in the claims. Rather, claimed subject matter may lie in less than all features of a single foregoing disclosed embodiment.

In some embodiments, the numbers expressing quantities or properties used to describe and claim certain embodiments of the present disclosure are to be understood as being modified in some instances by the term "about," "approximate," or "substantially." For example, "about," "approximate," or "substantially" may indicate ±20% variation of the value it describes, unless otherwise stated. Accordingly, in some embodiments, the numerical parameters set forth in the written description and attached claims are approximations that may vary depending upon the desired properties sought to be obtained by a particular embodiment. In some embodiments, the numerical parameters should be construed in light of the number of reported significant digits and by applying ordinary rounding techniques. Notwithstanding that the numerical ranges and parameters setting forth the broad scope of some embodiments of the present disclosure are approximations, the numerical values set forth in the specific examples are reported as precisely as practicable.

Each of the patents, patent applications, publications of patent applications, and other material, such as articles, books, specifications, publications, documents, things, and/or the like, referenced herein is hereby incorporated herein by this reference in its entirety for all purposes, excepting any prosecution file history associated with same, any of same that is inconsistent with or in conflict with the present document, or any of same that may have a limiting affect as to the broadest scope of the claims now or later associated with the present document. By way of example, should there be any inconsistency or conflict between the description, definition, and/or the use of a term associated with any of the incorporated material and that associated with the present document, the description, definition, and/or the use of the term in the present document shall prevail.

In closing, it is to be understood that the embodiments of the present disclosure disclosed herein are illustrative of the principles of the embodiments of the present disclosure. Other modifications that may be employed may be within the scope of the present disclosure. Thus, by way of example, but not of limitation, alternative configurations of the embodiments of the present disclosure may be utilized in accordance with the teachings herein. Accordingly, the embodiments of the present disclosure are not limited to that precisely as shown and described.

**Claims**

1. An acoustic device, comprising:

   a piezoelectric component configured to produce a vibration under an action of a driving voltage;
   a vibration component mechanically connected to the piezoelectric component to receive the vibration and produce sound; and
   a resistor element connected in series with the piezoelectric component to change a frequency response of the vibration component, wherein the resistor element is configured that a difference between a vibration amplitude of the vibration component at 10 kHz and a vibration amplitude of the vibration component at 1 kHz is less than or equal to 20 dB.

2. The acoustic device of claim 1, wherein the resistor element is connected in series with a positive electrode of the piezoelectric component.

3. The acoustic device of claim 2, wherein the resistor element is welded on the positive electrode of the piezoelectric component.

4. The acoustic device of any of claims 1-3, wherein the resistor element is connected in series with a negative electrode of the piezoelectric component.

5. The acoustic device of claim 4, wherein the resistor element is welded on the negative electrode of the piezoelectric component.

6. The acoustic device of claim 4 or claim 5, wherein the positive electrode and the negative electrode of the piezoelectric component are led out from a same side of the piezoelectric component.

7. The acoustic device of any of claims 1-6, wherein the resistor element includes a lead connected with the piezoelectric component.

8. The acoustic device of any of claims 1-7, wherein the resistor element includes a conductive adhesive connected with the piezoelectric component.

9. The acoustic device of any of claims 1-8, wherein the resistor element is arranged on a flexible circuit board.

10. The acoustic device of any of claims 1-9, wherein the resistor element includes an electrode of the piezoelectric component.

11. The acoustic device of claim 10, wherein at least part of the electrode of the piezoelectric component is made of one of: copper, gold, aluminum, tungsten, iron, or platinum.

12. The acoustic device of claim 10 or claim 11, wherein an effective cross-sectional area of at least part of the electrode of the piezoelectric component is less than a contour cross-sectional area of the electrode.

13. The acoustic device of claim 12, wherein a cross-section of at least part of the electrode of the piezoelectric component is a mesh structure or an S-shaped structure.

14. The acoustic device of any of claims 1-13, wherein a resistance value of the resistor element is within a range of $1\Omega$-$1k\Omega$.

15. The acoustic device of any of claims 1-14, wherein the piezoelectric component is a beam structure.

16. The acoustic device of claim 15, wherein the piezoelectric component includes at least two piezoelectric ceramic wafers, and the at least two piezoelectric ceramic wafers are electrically connected with each other.

17. The acoustic device of claim 16, wherein the at least two piezoelectric ceramic wafers are interleaved with electrodes of the piezoelectric component.

18. The acoustic device of any of claims 1-17, wherein a surface temperature of the piezoelectric component is lower than a Curie temperature of the piezoelectric component in an operation state.

19. The acoustic device of any of claims 1-18, wherein the vibration component includes:

an elastic element; and
a mass element, wherein one end of the elastic element is connected with the piezoelectric component, and the other end of the elastic element is connected with the mass element.

20. The acoustic device of claim 19, wherein the elastic element includes one of: a vibration transmitting sheet, an adhesive, an elastic sheet, or a substrate.

21. The acoustic device of claim 19 or claim 20, wherein the mass element includes a housing configured to accommodate the piezoelectric component and the resistor element.

22. The acoustic device of any of claims 1-21, wherein the acoustic device is a bone conduction acoustic device.

23. The acoustic device of any of claims 1-22, further comprising a boost electrical system configured to increase a voltage output from a power supply.

**100**        130                     120                    110

| Resistor Element | Piezoelectric Component | Vibration Component |

FIG. 1

100

110   121        120      122   130

FIG. 2

FIG. 3

FIG. 4

FIG. 5

**120**

1231　　　　　　　　　123　　　　　　　　　1232

+　　　　　　　　　　　　　　　　　　　　−

FIG. 6

FIG. 7

FIG. 8

FIG. 9

FIG. 10

+

120

1202

−

130

1201

FIG. 11A

1201

120

1202

+

−

130

131

FIG. 11B

130   +     -

131

1203   120

FIG. 11C

120
1202
130
+
1201

FIG. 11D

120
1202 130
+
1201
131

FIG. 11E

+
130
131
1203
120

FIG. 11F

FIG. 12

Electrode a

Electrode b    Electrode c

Electrode d

FIG. 13A

FIG. 13B

FIG. 13C

310

−

320

+

FIG. 13D

120

FIG. 13E

120

FIG. 13F

## INTERNATIONAL SEARCH REPORT

| International application No. |
| --- |
| **PCT/CN2022/079435** |

| A. | CLASSIFICATION OF SUBJECT MATTER |
| --- | --- |

H04R 1/10(2006.01)i;  H04R 9/04(2006.01)i

According to International Patent Classification (IPC) or to both national classification and IPC

| B. | FIELDS SEARCHED |
| --- | --- |

Minimum documentation searched (classification system followed by classification symbols)

H04R1/-;  H04R9/-;  H03K17/-;  F16F15/-;  H04R17/-;  A61F11/-;  G10K11/-;  H03H9/-

Documentation searched other than minimum documentation to the extent that such documents are included in the fields searched

Electronic data base consulted during the international search (name of data base and, where practicable, search terms used)

CNTXT; CNABS; CNKI: 百度文库, BAIDU WENKU: 压电, 齐心, 张磊, 频率, 深圳韶音科技有限公司, 电阻, 声音, 耳机, 音响, 朱光远, 骨传导, 串联, 频率响应, 音箱, 温度, 韶音科技, 改变, 振动, 振动组件, 声波, 幅值, 压电组件, 差异, 王庆 依；VEN; EPTXT; USTXT; WOTXT; IEEE: piezo, vibration, resistance, series, earphone, osteoconduction, bone conduction, frequency response, temperature

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| Y | CN 113596647 A (SHENZHEN VOXTECH CO., LTD.) 02 November 2021 (2021-11-02) description, paragraphs 27-98 | 1-23 |
| Y | CN 108119603 A (NANJING UNIVERSITY OF AERONAUTICS AND ASTRONAUTICS) 05 June 2018 (2018-06-05) description, paragraphs 7-20 | 1-23 |
| Y | CN 113596684 A (SHENZHEN VOXTECH CO., LTD.) 02 November 2021 (2021-11-02) description, paragraphs 27-98 | 1-23 |
| A | CN 208174657 U (SUZHOU PANT PIEZOELECTRIC TECHNOLOGY CO., LTD.) 30 November 2018 (2018-11-30) entire document | 1-23 |
| A | CN 210639985 U (GUILIN UNIVERSITY OF ELECTRONIC TECHNOLOGY et al.) 29 May 2020 (2020-05-29) entire document | 1-23 |
| A | US 2013245362 A1 (Rasmus Elofsson) 19 September 2013 (2013-09-19) entire document | 1-23 |

☐ Further documents are listed in the continuation of Box C.  ☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **11 November 2022** | **30 November 2022** |

| Name and mailing address of the ISA/CN | Authorized officer |
| --- | --- |
| **China National Intellectual Property Administration (ISA/ CN)** **No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

**INTERNATIONAL SEARCH REPORT**
Information on patent family members

International application No.

**PCT/CN2022/079435**

| Patent document cited in search report | | | Publication date (day/month/year) | Patent family member(s) | | | Publication date (day/month/year) |
|---|---|---|---|---|---|---|---|
| CN | 113596647 | A | 02 November 2021 | WO | 2021217670 | A1 | 04 November 2021 |
| CN | 108119603 | A | 05 June 2018 | CN | 108119603 | B | 11 October 2019 |
| CN | 113596684 | A | 02 November 2021 | None | | | |
| CN | 208174657 | U | 30 November 2018 | CN | 108649945 | A | 12 October 2018 |
| CN | 210639985 | U | 29 May 2020 | None | | | |
| US | 2013245362 | A1 | 19 September 2013 | US | 8858420 | B2 | 14 October 2014 |

Form PCT/ISA/210 (patent family annex) (January 2015)